# EUROPEAN PATENT SPECIFICATION

(11) **EP 3 079 376 B1**
(45) Date of publication and mention of the grant of the patent: **17.02.2021**
(21) Application number: 14867725.5
(22) Date of filing: 01.09.2014
(51) Int. Cl.: H04R 3/00, B60R 11/02, H04R 3/04, H03G 3/32, H03G 5/16, H04R 29/00

(54) **ACOUSTIC DEVICE, ACOUSTIC PROCESSING METHOD, AND ACOUSTIC PROCESSING PROGRAM**
AKUSTISCHE VORRICHTUNG, AKUSTISCHES VERARBEITUNGSVERFAHREN UND AKUSTISCHES VERARBEITUNGSPROGRAMM
DISPOSITIF ACOUSTIQUE, PROCÉDÉ DE TRAITEMENT ACOUSTIQUE, ET PROGRAMME DE TRAITEMENT ACOUSTIQUE

(30) Priority: 06.12.2013 JP 2013253346
(43) Date of publication of application: 12.10.2016
(73) Proprietor: JVC Kenwood Corporation, Yokohama-shi, Kanagawa 221-0022 (JP)
(72) Inventor: NAKAMURA, Masami, Yokohama-shi Kanagawa 221-0022 (JP)
(74) Representative: Schmidbauer, Andreas Konrad
(86) International application number: PCT/JP2014/072961
(87) International publication number: WO 2015/083403

(56) References cited:
- EP-A1- 1 876 706
- EP-A1- 1 986 466
- EP-A1- 2 136 362
- JP-A- H0 787 587
- JP-A- H11 298 990
- JP-A- 2013 062 609
- US-A- 4 944 018
- Anonymous: "A-weighting - Wikipedia", , 9 April 2008 (2008-04-09), XP055592411, Retrieved from the Internet: URL:https://en.wikipedia.org/w/index.php?t itle=A-weighting&oldid=204480376 [retrieved on 2019-05-28]

## Description

### Field

The present invention relates to an acoustic device, an acoustic processing method, and a computer-readable recording medium having stored therein a program that causes a computer to effectively equalize vehicle audio.

### Background

In a vehicle mounted acoustic playback device that is used to play back music or the like in the interior of a vehicle, when music or the like is played back during the travelling of the vehicle, a playback sound is sometimes hard to hear. This is because the playback sound is masked by road noise generated in accordance with the travelling. The road noise is noise generated due to tread patterns of tires being beaten on a road surface. The road noise generally has a frequency characteristic containing a lot of low frequency components.

Conventionally, there is a known method of measuring the number of rotations of a vehicle engine or measuring a vehicle vibration by using a microphone, a vehicle speed pulse, or the like and controlling the sound volume of a playback sound or the like by using the measurement value as input information that is correlated with the road noise. For example, the sound volume of the playback sound is increased as the amount of generated road noise to decrease the masking of the playback sound due to the road noise.

JP H7-87587 A discloses a technology that detects a vehicle speed or an opened/closed state of a roof as information that is correlated with road noise and that performs equalizing correction on a playback sound on the basis of the detection result. In JP H7-87587 A, the sound volume of the playback sound in the low frequency is made to increase and the sound volume in the high frequency is made to decrease, whereby the masking of the playback sound due to the road noise is dissolved.

In contrast, as indicated by equal-loudness contours originated by Fletcher and Munson, it is known that, as the characteristic of human auditory, sensitivity in the low frequency and the high frequency is decreased as a sound becomes weak. Consequently, conventionally, in an audio playback device, correction that enhances the low frequency and the high frequency regions as the volume value is small is performed on the basis of the equal-loudness contours in accordance with volume values.

EP 1 876 706 A discloses a sound reproducing apparatus which is configured such that a correction amount is calculated on the basis of a masking model, determiner for determining a correction parameter correcting input signal so as to be natural for human ears to hear on the basis of the calculated correction amount is provided, and a characteristic of correction filter is changed on the basis of a result of determiner when inputting vehicle speed information.

EP 1 986 466 A discloses a method for automated tuning of a sound system.

EP 2 136 362 A discloses an audio signal processing device and audio signal processing method. US 4 944 018 A discloses a vehicle dynamic equalization system modifying dynamic range as a function of vehicle speed.

### Summary

### Technical Problem

Conventionally, in order to dissolve the masking due to road noise with respect to a playback sound of an audio signal, the sound volume of the playback sound of the audio signal in the low frequency is increased in accordance with the frequency characteristic of the road noise. However, in the conventional method, there is a problem in that it is difficult to perform control such that a playback sound in the low frequency is appropriately heard while the masking due to the road noise in the low frequency is being suppressed.

Furthermore, because high frequency components are also included in the road noise even though the level thereof is lower than that of low frequency components, the low level components among the high frequency components of the playback sounds that are output from a speaker are masked by the high frequency components of the road noise. Even when the sound volume of the playback sounds of the audio signal in the high frequency is increased in accordance with the frequency characteristic of the road noise in order to dissolve this similarly to the case described above, it is difficult to perform control such that the high frequency is appropriately heard.

Accordingly, the present invention has been conceived in light of the circumstances described above, and an object thereof is to appropriately suppress the effect of external noise with respect to a playback sound.

### Solution to Problem

In accordance with the present invention, an acoustic device, an acoustic processing method, and a computer-readable recording medium are defined in the appended claims. Further embodiments are inter alia disclosed in the dependent claims.

### Advantageous Effects of Invention

According to the present invention, an advantage is provided in that it is possible to appropriately suppress the effect of external noise with respect to a playback sound.

### Brief Description of Drawings

FIG. 1 is a block diagram illustrating a configuration of a first example of a car audio device which does not form part of the invention as defined by the appended claims.
FIG. 2 is a functional block diagram illustrating an example of a function of a control unit according to the first example.
FIG. 3 is a functional block diagram illustrating an example of a function of a road noise correction unit according to the first example.
FIG. 4 is a schematic diagram illustrating equal-loudness contours.
FIG. 5 is a schematic diagram illustrating conversion of frequency characteristics of a road noise signal by using the A characteristic according to the first embodiment.
FIG. 6 is a schematic diagram illustrating conversion of frequency characteristics of a road noise signal by using the A characteristic according to the first example.
FIG. 7 is a schematic diagram illustrating an example of frequency characteristics that are set in an equalizer according to the first example.
FIG. 8 is a flowchart illustrating an example of a process accroding to the first example.
FIG. 9 is a flowchart illustrating an example of a process according to a modification of the first example.
FIG. 10 is a schematic diagram illustrating a second example which does not form part of the invention as defined by the appended claims.
FIG. 11 is a block diagram illustrating a configuration of an example of a car audio device according to the invention.
FIG. 12 is a functional block diagram illustrating an example of a function of a control unit according to the second example.
FIG. 13 is a functional block diagram illustrating an example of a function of a road noise correction unit according to the second example.
FIG. 14 is a flowchart illustrating an example of a process according to the second example.
FIG. 15 is a flowchart illustrating an example of a process according to the invention.
FIG. 16 is a functional block diagram illustrating an example of a function performed by a road noise correction unit according to the invention.

### Description of Examples

Preferred embodiments of an acoustic device, an acoustic processing method, and an acoustic processing program according to the present invention will be described with reference to accompanying drawings. Specific numerical values, the external configurations, and the like represented are merely examples used for easy understanding of the present invention but are not for the purpose of limiting the present invention unless otherwise mentioned. In addition, elements not directly relating to the present invention are not described in detail and are not presented in the drawings.

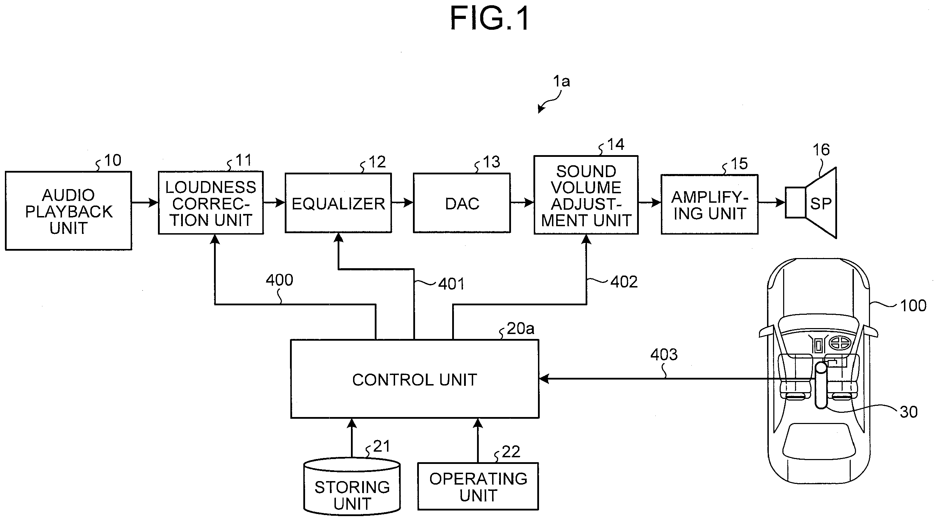

First Example FIG. 1 is a block diagram illustrating a configuration of an example of an in- vehicle acoustic playback device (hereinafter, referred to as a car audio device) that can be used for a first example. In FIG. 1, a car audio device 1a is used by being mounted on a vehicle 100. The car audio device 1a includes an audio playback unit 10, a loudness correction unit 11, an equalizer 12, a digital/analog convertor (DAC) 13, a sound volume adjustment unit 14, an amplifying unit 15, and a speaker (SP) 16. Furthermore, the car audio device 1a includes a control unit 20a, a storing unit 21, and an operating unit 22.

The audio playback unit 10 plays back audio data recorded in a disk recording medium, such as a compact disk (CD), or a nonvolatile semiconductor memory and outputs the audio data as an audio signal of a digital system. The audio signal that is output from the audio playback unit 10 is supplied to the loudness correction unit 11. The loudness correction unit 11 performs, on the supplied audio signal, correction (loudness correction) of the frequency characteristics in accordance with the equal-loudness contours on the basis of a loudness correction value 400 that is supplied from the control unit 20a.

The audio signal that is output from the loudness correction unit 11 is supplied to the equalizer 12. The equalizer 12 performs, on the supplied audio signal, correction of the frequency characteristics in accordance with a parameter 401 supplied from the control unit 20a. The audio signal that is output from the equalizer 12 is converted to an audio signal of an analog system by the DAC 13 and is then supplied to the sound volume adjustment unit 14.

In accordance with a sound volume control value 402 supplied from the control unit 20a, the sound volume adjustment unit 14 adjusts the level of the audio signal supplied from the DAC 13. The audio signal whose level has been adjusted by the sound volume control unit 14 is subjected to power amplification by the amplifying unit 15 and supplied to the speaker 16 that is attached in the interior of the vehicle 100.

The control unit 20a includes, for example, a central processing unit (CPU), a read only memory (ROM), a random access memory (RAM), and interfaces with respect to the loudness correction unit 11, the equalizer 12, and the sound volume adjustment unit 14 described above. However, not limited to this, the control unit 20a may also further include an interface with respect to the audio playback unit 10. In the control unit 20a, the CPU works in accordance with the programs stored in the ROM in advance, using the RAM as a work memory, and controls each of the units described above via the interfaces.

The storing unit 21 is, for example, a nonvolatile semiconductor memory or a hard disk drive and stores therein various kinds of data that is used by the control unit 20a. The operating unit 22 receives an operation performed by a user and supplies the control signal in accordance with the user operation to the control unit 20a. The control unit 20a controls the audio playback unit 10, the loudness correction unit 11, the equalizer 12, and the sound volume adjustment unit 14 in accordance with the control signal supplied from the operating unit 22, whereby the user can allow the car audio device 1a to perform the operation in accordance with the operation.

Furthermore, in the first example, an audio signal that is output from a microphone 30 arranged in the vehicle 100 and that is on the basis of the voice picked up by the microphone 30 is input to the car audio device 1a. The audio signal that is output from the microphone 30 and that is input to the car audio device 1a is supplied to the control unit 20a.

For example, the microphone 30 picks up road noise that is caused by a sound generated due to tread patterns of tires of the travelling vehicle 100 being beaten on a road surface and that is conveyed to the interior of the vehicle 100 and then supplies the audio signal of the road noise to the control unit 20a. In the following, the audio signal of this road noise is referred to as a road noise signal 403 unless otherwise noted. The road noise is external noise with respect to the sound that is output from the speaker 16 of the car audio device 1a.

Furthermore, mechanical noise, such as an engine sound or the like of the travelling vehicle 100, may also be picked up together with the road noise by the microphone 30 as the external noise with respect to the playback sound of the speaker 16.

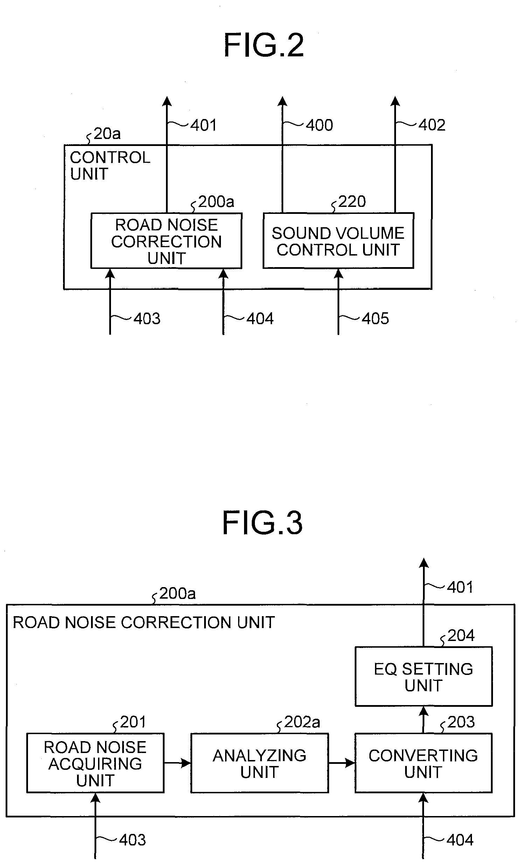

FIG. 2 is a functional block diagram illustrating an example of the function of the control unit 20a according to the first example. The control unit 20a includes a road noise correction unit 200a and a sound volume control unit 220. The road noise correction unit 200a and the sound volume control unit 220 are constituted by the programs running on the CPU included in the control unit 20a. However, the configuration is not limited to this, and the road noise correction unit 200a and the sound volume control unit 220 may also be constituted by individual hardware.

The road noise signal 403 that is supplied from the microphone 30 is input to the road noise correction unit 200a. Furthermore, a conversion coefficient 404 that is used to convert the frequency characteristic of the road noise signal 403 to the frequency characteristic in accordance with the characteristic of human auditory is input to the road noise correction unit 200a. The road noise correction unit 200a creates the parameter 401 on the basis of the input road noise signal 403 and the conversion coefficient 404 and supplies the created parameter 401 to the equalizer 12.

The control signal that is output from the operating unit 22 in accordance with the operation performed by a user is input to the sound volume control unit 220 as an operation input 405. The sound volume control unit 220 creates, for example, the sound volume control value 402 in accordance with the operation input 405 and supplies the sound volume control value 402 to the sound volume adjustment unit 14. Furthermore, the sound volume control unit 220 creates the loudness correction value 400 in accordance with the sound volume control value 402 and supplies the loudness correction value 400 to the loudness correction unit 11.

FIG. 3 is a functional block diagram illustrating an example of the function of the road noise correction unit 200a according to the first example. The road noise correction unit 200a includes a road noise acquiring unit 201, an analyzing unit 202a, a converting unit 203, and an EQ setting unit 204. The road noise acquiring unit 201, the analyzing unit 202a, the converting unit 203, and the EQ setting unit 204 are constituted by an acoustic processing program running on the CPU included in the control unit 20a. However, the configuration is not limited to this, and the road noise acquiring unit 201, the analyzing unit 202a, the converting unit 203, and the EQ setting unit 204 may also be constituted by individual hardware. Furthermore, the function of the sound volume control unit 220 described above may also be included in the acoustic processing program.

Furthermore, the acoustic processing program described above is stored in, for example, the ROM included in the control unit 20a in advance and provided. However, the configuration is not limited to this. For example, it may also be possible to arrange in the car audio device 1a a nonvolatile memory or an interface that connects a drive for playing back a CD or a digital versatile disk (DVD) and supply the acoustic processing program from the nonvolatile memories or a recording medium, such as a CD, a DVD, or the like. Furthermore, it may also be possible to arrange a communication interface for connecting the car audio device 1a to the Internet and supply the acoustic processing program from the Internet.

The road noise acquiring unit 201 acquires the road noise signal 403 that is supplied from the microphone 30. For example, the road noise acquiring unit 201 converts the road noise signal 403 that is supplied in an analog system to the signal of a digital system and temporarily stores the signal in the memory. The analyzing unit 202a analyzes, by using, for example, Fourier transformation, a frequency characteristic of the road noise signal 403 acquired by the road noise acquiring unit 201. The analysis result is supplied to the converting unit 203.

The converting unit 203 converts the frequency characteristic of the road noise signal 403 analyzed by the analyzing unit 202a to a frequency characteristic that takes into consideration a human auditory characteristic (auditory sensitivity characteristic) in accordance with the conversion coefficient 404. In the following, the process performed by the converting unit 203 will be described.

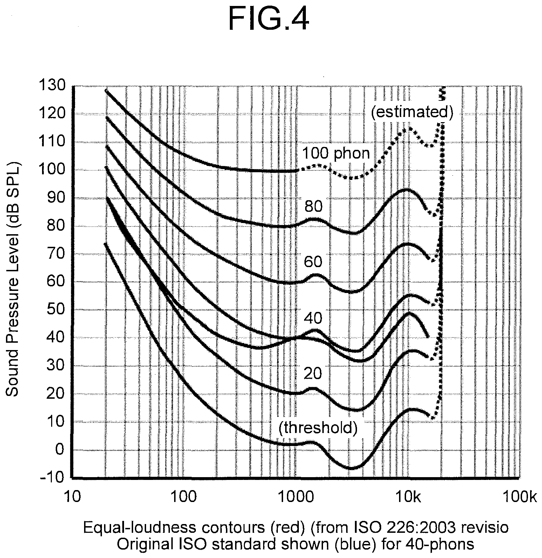

A person detects aerial vibrations by the ear, whereby the brain recognizes as a sound. At this time, the person perceives, in accordance with the auditory characteristic, the sound with the frequency characteristic that is different from the frequency characteristic of the sound that is actually emitted as the aerial vibration. Specifically, as indicated by the equal-loudness contours (International Organization for Standardization (ISO) 226) measured by Fletcher and Munson illustrated in FIG. 4, for the human auditory, the sensitivity to the low frequency and the high frequency in the mid frequency range (for example, 1 kHz to 5 kHz) is low and, furthermore, when a sound volume (sound pressure) is decreased, the sensitivity to the low frequency and the high frequency with respect to the mid frequency remarkably decreased. Furthermore, a decrease in sensitivity is further remarkable in the low frequency than the high frequency.

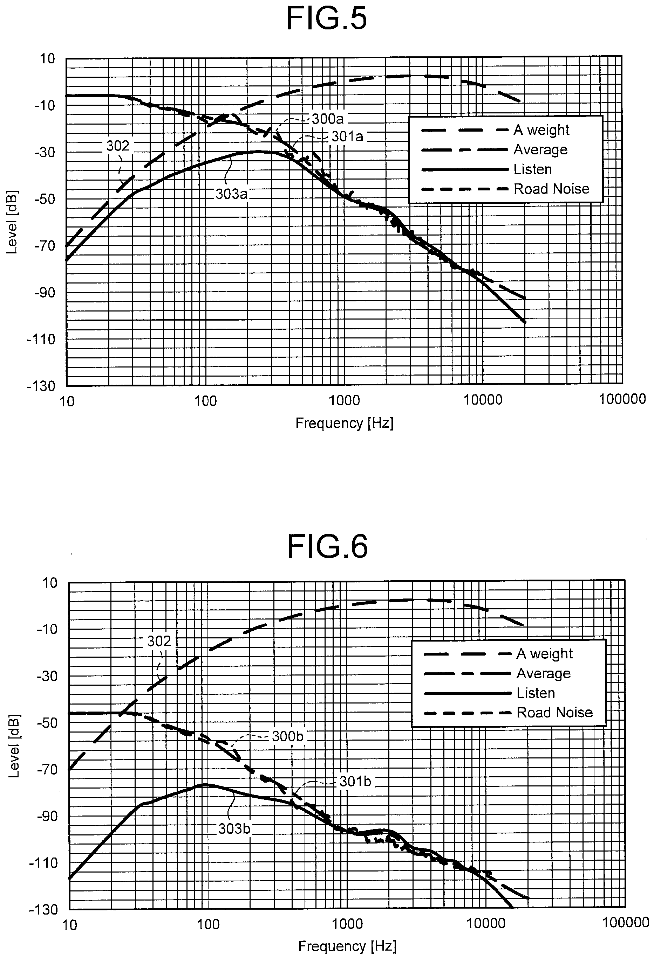

As one of the frequency weighting characteristics used to convert a frequency characteristic that is based on the actual measurement value of a sound to a frequency characteristic that takes into consideration of the human auditory characteristic described above, the characteristic referred to as the A characteristic is prescribed. Conversion of a frequency characteristic of the road noise signal 403 performed by using the A characteristic according to the first embodiment will be described with reference to FIG. 5. FIG. 5 is a schematic diagram in which the reference level of the audio signal of a digital system is shown as 0 dB.

In FIG. 5, a curve 302 indicates the A characteristic. The A characteristic is a characteristic of the frequency weighting that takes into consideration the human auditory and that is used to mainly measure the noise level and is prescribed in JIS C1509 series "electricity acoustic -sound level meter (noise meter)". The A characteristic indicates, as indicated by the curve 302 illustrated in FIG. 5, the frequency characteristic indicating that the sound pressure level is a peak about 2,000 Hz to 3,000 Hz and is decreased toward each of the low frequency side and the high frequency side.

In FIG. 5, a curve 300a indicates an example of the frequency characteristic of the road noise signal 403, i.e., the actual measurement value of the road noise, and a curve 301a is indicated as the average of the curve 300a. As indicated by the curves 300a and 301a, the road noise signal 403 is a signal with the frequency characteristic in which the level is increased from the high frequency toward the low frequency and a lot of low frequency components are included. In the following, the frequency characteristic that is indicated by the curve 301a obtained by averaging the curve 300a is referred to as the frequency characteristic of the road noise signal 403.

In FIG. 5, a curve 303a indicates the frequency characteristic obtained after the conversion by converting the frequency characteristic indicated by the curve 301a to the characteristic that takes into consideration of the human auditory by using the A characteristic frequency weighting indicated by the curve 302. As indicated by the curve 303a, by converting the frequency characteristic by using the A characteristic frequency weighting, it is possible to obtain the frequency characteristic indicating that the sound pressure level is a peak at about 200 Hz to 300 Hz and is decreased toward each of the low frequency side and the high frequency side. Furthermore, the converted frequency characteristic indicates that a peak is present at about 1,500 Hz that is close to the peak of the frequency characteristic of the A characteristic. The frequency characteristic indicated by the curve 303a can be considered as the frequency characteristic of the road noise that can be heard and perceived by a person. More specifically, the component of the road noise at about 200 Hz to 300 Hz is easily perceived by the human ear and the component of the road noise at about 1,500 Hz is subsequently easily perceived.

FIG. 6 indicates an example in which the road noise is lower than the road noise illustrated in FIG. 5 and the level of the road noise signal 403 is lower than the curve 301a (curve 300a) illustrated in FIG. 5. Namely, in FIG. 6, a curve 300b is the frequency characteristic of the road noise signal 403 and the frequency characteristic that is obtained by averaging the characteristic of the curve 300b are indicated by a curve 301b. In this case, if the frequency characteristic of the road noise signal 403 is converted by using the A characteristic frequency weighting, as indicated by a curve 303b illustrated in FIG. 6, the frequency characteristic that has the level, on the whole, lower than that of the curve 303a illustrated in FIG. 5. In this case, the converted frequency characteristic indicates that a peak is present at about 100 Hz and about 1,500 Hz and indicates that the sounds of these frequency components can be easily perceived by a human ear.

For example, in the example illustrated in FIG. 5, from among voices output from the speaker 16 in a car audio device 1, the components equal to or less than the curve 303a are masked by the road noise and thus are not heard by a person. Consequently, the road noise correction unit 200a according to the first embodiment corrects the frequency characteristic of the audio signal that is output from the audio playback unit 10 by the frequency characteristic in accordance with the curve 303a, whereby the road noise correction unit 200a suppresses the masking of the playback sound due to the road noise.

More specifically, the information that indicates the frequency characteristic due to the A characteristic indicated by the curve 302 is previously stored in the storing unit 21. The converting unit 203 acquires, from the storing unit 21, the information that indicates the frequency weighting of the A characteristic like the curve 302 as the conversion coefficient 404. The converting unit 203 converts, by using the conversion coefficient 404, the frequency characteristic of the road noise signal 403 that is indicated by the curve 301a (curve 300a) and that is supplied from the analyzing unit 202a and acquires the converted frequency characteristic that is indicated by the curve 303a.

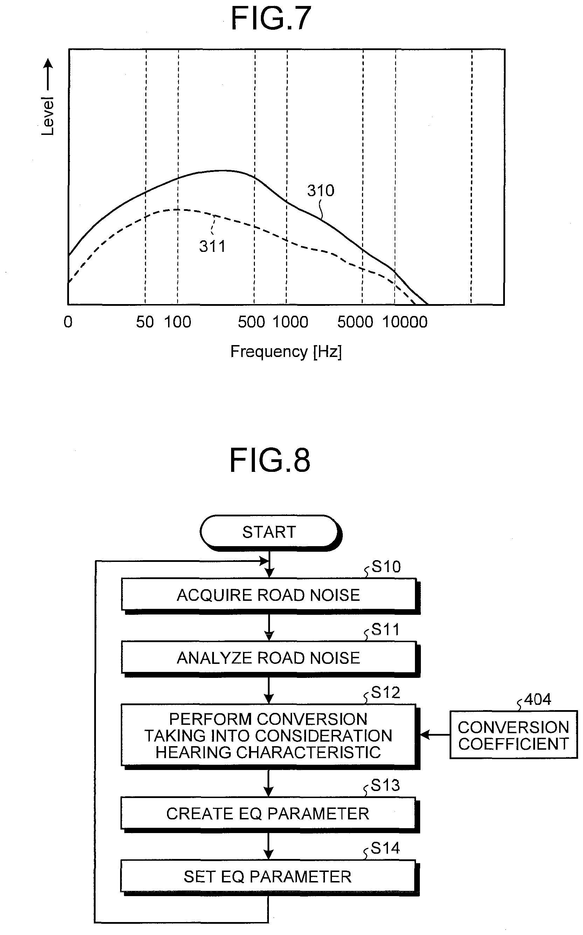

The converting unit 203 supplies the information that indicates the acquired converted frequency characteristic to the EQ setting unit 204. The EQ setting unit 204 creates, on the basis of the information indicating the converted frequency characteristic that is supplied from the converting unit 203, the parameter 401 that is used to perform correction of the frequency characteristic of the audio signal in the equalizer 12. For example, the EQ setting unit 204 creates the parameter 401 that has a characteristic such that the equalizer 12 increases the level for each frequency of the audio signal associated with the curve 303a, as exemplified by a curve 310 illustrated in FIG. 7. The parameter 401 is a filter coefficient with respect to, for example, a digital filter that constitutes the equalizer 12.

Furthermore, a curve 311 illustrated in FIG. 7 indicates an example of the frequency characteristic of the equalizer 12 that is set in association with the curve 303b when road noise is low illustrated in FIG. 6. In this way, the frequency characteristic that is set in the equalizer 12 varies in accordance with the magnitude of the road noise.

The EQ setting unit 204 sets the created parameter 401 in the equalizer 12. The equalizer 12 corrects the frequency characteristic with respect to the audio signal that is supplied in accordance with the set parameter 401, whereby the level of the frequency band that is masked by the road noise is increased and thus the masking can be suppressed.

FIG. 8 is a flowchart illustrating an example of a process according to the first example. In the road noise correction unit 200a, the road noise acquiring unit 201 acquires, at Step S10, the road noise signal 403 that is output from the microphone 30. At the subsequent Step S11, the analyzing unit 202a analyzes the road noise signal 403 that is acquired at Step S10 and acquires the frequency characteristic. At the subsequent Step S12, by using, for example, the conversion coefficient 404 on the basis of the A characteristic frequency weighting that is indicated by the curve 302 and that is read from the storing unit 21, the converting unit 203 converts the frequency characteristic of the road noise signal 403 analyzed by the analyzing unit 202a at Step S11 to the frequency characteristic that takes into consideration the auditory characteristic.

At the subsequent Step S13, the EQ setting unit 204 creates the parameter 401 of the equalizer 12 that is used to correct the frequency characteristic of the audio signal in accordance with the frequency characteristic that is converted by the converting unit 203 at Step S12. Then, the EQ setting unit 204 sets, in the equalizer 12, the parameter 401 created at the subsequent Step S14.

By repeatedly performing the processes at Step S10 to Step S14 described above at a predetermined interval, it is possible to suppress the masking of the road noise generated in the vehicle 100 with respect to the playback sound of the car audio device 1a in substantially real time.

Conventionally, the parameter 401 of the equalizer 12 is set by using, for example, the frequency characteristic itself of the road noise signal 403 indicated by the curve 301a illustrated in FIG. 5. In this case, because the road noise signal 403 is not taken into consideration the auditory characteristic of a person, the attenuation of the low frequency and the high frequency due to, for example, the A characteristic frequency weighting is not considered. Consequently, with the conventional technology, the level of the low frequency or the high frequency in which perception in the human auditory characteristic is decreased is excessively increased.

The road noise is not a sound that is included in the audio signal that is output from the audio playback unit 10 but is a sound that is directly heard by a person. Consequently, as described in the first example, by setting the parameter 401 of the equalizer 12 on the basis of the frequency characteristic that is obtained by converting the frequency characteristic of the road noise signal 403 in accordance with the auditory characteristic of a person by using, for example, the A characteristic frequency weighting, it is possible to suppress the masking with respect to a sound that is output from the speaker 16 due to the road noise that is directly heard by the person.

Modification of the first example In the following, a modification of the first example will be described. In the above description, the A characteristic frequency weighting is used in order to convert the frequency characteristic of the road noise signal 403 to the frequency characteristic that takes into consideration the auditory characteristic; however, the example is not limited thereto. In the first example, the conversion of this frequency characteristic is performed on the basis of the equal-loudness contours measured by Fletcher and Munson. For example, it is conceivable that conversions of the frequency characteristics are performed in accordance with the characteristics of reversing the depressions and protrusions of the equal-loudness contours.

As has been described with reference to FIG. 4, according to the equal-loudness contours, the frequency characteristic of the human auditory varies in accordance with the magnitude of a sound. Thus, in the first example, in the road noise correction unit 200a, the analyzing unit 202a further acquires the level of the road noise signal 403 and the converting unit 203 acquires the conversion coefficient 404 that is in accordance with the signal level of the road noise signal 403.

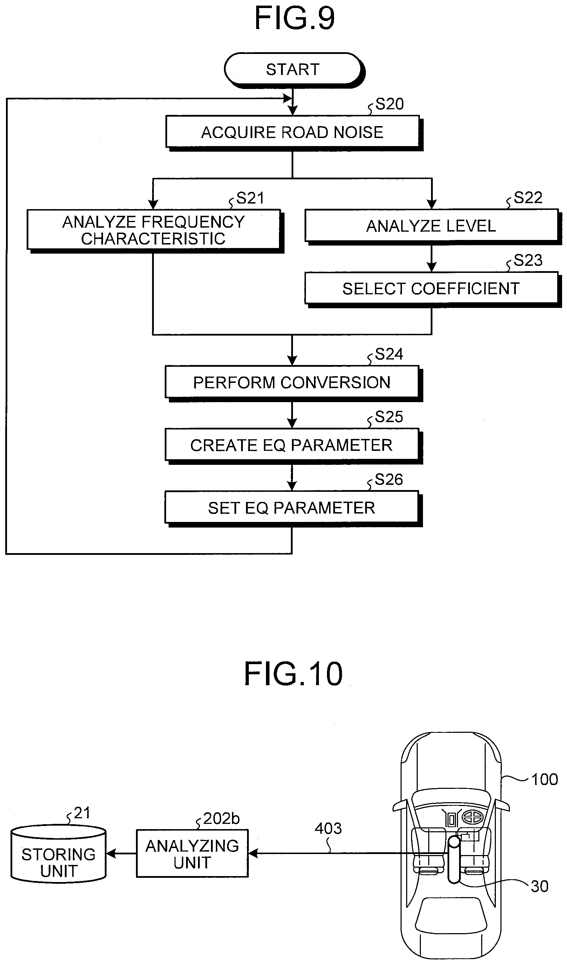

FIG. 9 is a flowchart illustrating an example of a process according to a modification of the first example. The process performed in the flowchart illustrated in FIG. 9 will be described with reference to the configuration illustrated in FIG. 3 described above. In the road noise correction unit 200a, the road noise acquiring unit 201 acquires, at Step S20, the road noise signal 403 that is output from the microphone 30. The analyzing unit 202a analyzes the acquired road noise signal 403 and acquires the frequency characteristic (Step S21).

Furthermore, the analyzing unit 202a analyzes the acquired road noise signal 403 and acquires the signal level (Step S22). At the subsequent Step S23, the converting unit 203 selects the conversion coefficient 404 that is associated with the signal level acquired at Step S22. For example, the converting unit 203 creates, on the basis of the equal-loudness contours, each of the conversion coefficients 404 associated with the each stage of the signal level and stores them in the storing unit 21 in advance. The converting unit 203 selects, in accordance with the signal level acquired at Step S22, the associated conversion coefficient 404 from the conversion coefficients 404 stored in the storing unit 21.

After the processes at Step S21 and Step S23 have been ended, the process is moved to Step S24. At Step S24, the converting unit 203 converts, by using the conversion coefficient 404 selected at Step S23, the frequency characteristic of the road noise signal 403 acquired at Step S21 to the frequency characteristic that takes into consideration the auditory characteristic.

At subsequent Step S25, the EQ setting unit 204 creates the parameter 401 of the equalizer 12 for correcting the frequency characteristic of the audio signal in accordance with the frequency characteristic converted by the converting unit 203 at Step S24. Then, the EQ setting unit 204 sets the created parameter 401 in the equalizer 12 at the subsequent Step S26.

By repeatedly performing the processes at Step S20 to Step S26 described above at a predetermined interval, it is possible to suppress the masking of the road noise generated in the vehicle 100 with respect to the playback sound of the car audio device 1a in substantially real time on the basis of the equal-loudness contours.

Second example In the following, a second example will be described. A car audio device according to the second example previously picks up, for each condition in which the magnitude of the road noise varies, the road noise generated in a vehicle; acquires the frequency characteristic of each of the road noise signals 403; and allows the storing unit to store the road noise signals. Then, the car audio device acquires the condition during the travelling of the vehicle; selects the frequency characteristic of the road noise signal 403 associated with the acquired condition from the storing unit; and performs a conversion process that converts the selected frequency characteristic to a frequency characteristic that takes into consideration the auditory characteristic.

The car audio device according to the second example can consequently suppress the masking of the road noise with respect to the playback sound of the car audio device without picking up the road noise by the microphone during the travelling of the vehicle.

A description will be given with reference to FIGS. 10 to FIG. 13 in more detail. Furthermore, in FIG. 10 to FIG. 13, components that are the same as those in FIG. 1 are assigned the same reference numerals and descriptions thereof will be omitted. In FIG. 10, an analyzing unit 202b previously analyzes the road noise signal 403 that is obtained by picking up the road noise of the vehicle 100 by the microphone 30 and acquires the frequency characteristic of the road noise signal 403. Then, the analyzing unit 202b allows the storing unit 21 to store the information that indicates the acquired frequency characteristic. The analyzing unit 202b performs this process on each of the conditions in each of which the road noise at the time of the travelling of the vehicle 100 varies and allows the storing unit 21 to store the conditions and information that indicates the frequency characteristics by associating with each other.

In the second example, as the conditions in each of which road noise varies, a travelling speed of the vehicle 100 is used. For example, the magnitude of the road noise becomes larger as the travelling speed of the vehicle 100 is increased, whereas the magnitude of the road noise becomes smaller as the travelling speed is decreased. Thus, by picking up the road noise respectively for each of a plurality of travelling speeds, the frequency characteristic of each of the road noise signals 403 is analyzed by the analyzing unit 202b. The analyzing unit 202b allows the storing unit 21 to store, in an associated manner, the information that indicates the frequency characteristic of the road noise signal 403 and the travelling speed.

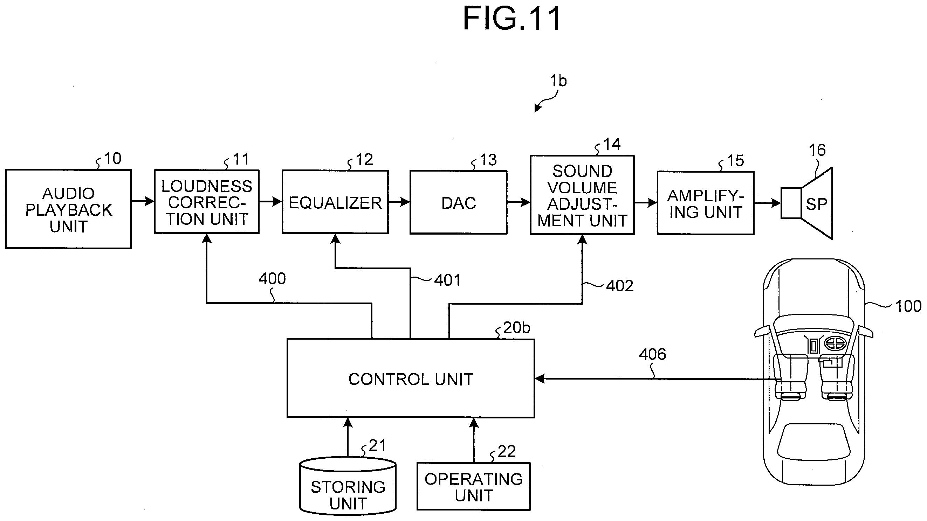

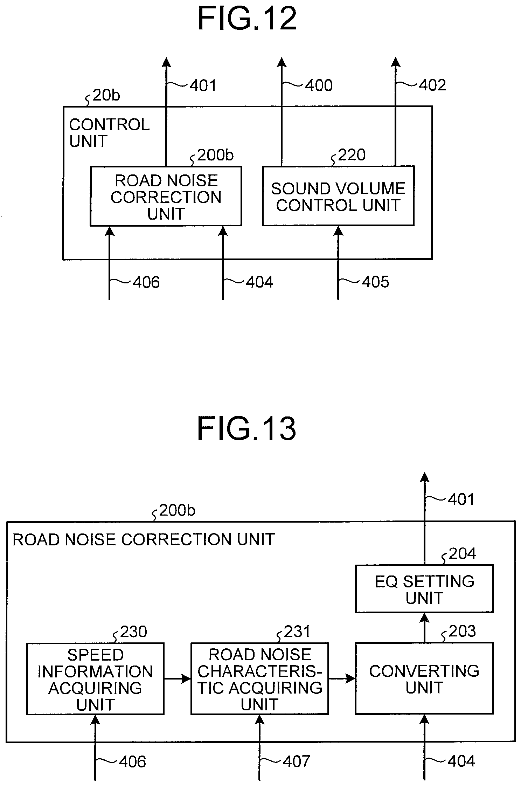

FIG. 11 indicates the configuration of an example of a car audio device 1b according to the second example. In FIG. 11, as speed information 406 that indicates the travelling speed of the vehicle 100, for example, a vehicle speed pulse is supplied from the vehicle 100 to a control unit 20b. The control unit 20b includes, as exemplified in FIG. 12, a road noise correction unit 200b and a sound volume control unit 220. The speed information 406 is supplied to the road noise correction unit 200b.

FIG. 13 is a functional block diagram illustrating an example of the function of the road noise correction unit 200b according to the second example. The road noise correction unit 200b includes, instead of the road noise acquiring unit 201 and the analyzing unit 202a in the road noise correction unit 200a illustrated in FIG. 3, a speed information acquiring unit 230 and a road noise characteristic acquiring unit 231.

Furthermore, the analyzing unit 202b illustrated in FIG. 10 may also be included in the road noise correction unit 200b or the control unit 20b or may also be arranged outside the control unit 20b or, furthermore, outside the car audio device 1b.

The vehicle speed information acquiring unit 230 receives a supply of the speed information 406 from the vehicle 100. The vehicle speed information acquiring unit 230 acquires the travelling speed of the vehicle 100 on the basis of the speed information 406 that is supplied as the vehicle speed pulse. The vehicle speed information acquiring unit 230 supplies the acquired travelling speed to the road noise characteristic acquiring unit 231.

On the basis of the travelling speed supplied from the vehicle speed information acquiring unit 230, the road noise characteristic acquiring unit 231 selects and acquires, from the storing unit 21, information that indicates the frequency characteristic (road noise characteristic) 407 associated with the travelling speed, that is previously acquired by the analyzing unit 202b in a manner described with reference to FIG. 10, and stored. The information that indicates the acquired frequency characteristic is supplied to the converting unit 203. The converting unit 203 acquires the conversion coefficient 404 on the basis of the frequency characteristic that takes into consideration the auditory characteristic from, for example, the storing unit 21.

Here, as the frequency characteristic that takes into consideration the auditory characteristic, the A characteristic frequency weighting described in the first example is used. However, the frequency characteristic that takes into consideration the auditory characteristic is not limited to this. As the frequency characteristic that takes into consideration the auditory characteristic, as has been described in the modification of the first example, the characteristic on the basis of the equal-loudness contours may also be used. In this case, it is conceivable that the characteristic is selected in accordance with a travelling speed.

Similarly to the first example, the converting unit 203 converts, by using the conversion coefficient 404, the frequency characteristic 407 indicated by the information acquired from the road noise characteristic acquiring unit 231 and acquires the converted frequency characteristic. The converted frequency characteristic is supplied to the EQ setting unit 204. In the same way as described above, the EQ setting unit 204 creates the parameter 401 of the equalizer 12 in accordance with the supplied converted frequency characteristic and sets the parameter 401 in the equalizer 12.

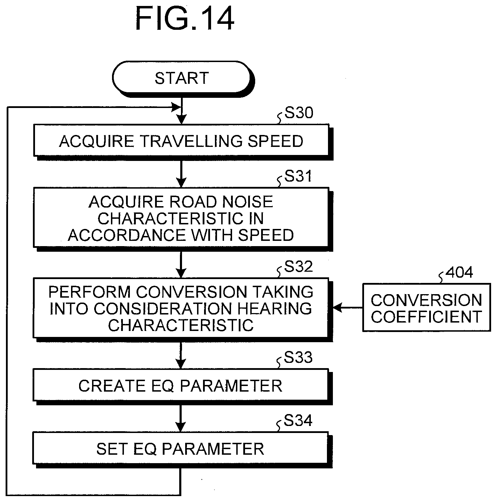

FIG. 14 is a flowchart illustrating the process according to the second example. In the road noise correction unit 200b, the vehicle speed information acquiring unit 230 acquires, at Step S30, the travelling speed of the vehicle 100 on the basis of the speed information 406 supplied from the vehicle 100. At the subsequent Step S31, the road noise characteristic acquiring unit 231 acquires, from the storing unit 21, the frequency characteristic 407 of the road noise signal 403 that is associated with the travelling speed acquired at Step S30.

At the subsequent Step S32, the converting unit 203 converts, by using, for example, the conversion coefficient 404 on the basis of the A characteristic read from the storing unit 21, the frequency characteristic of the road noise signal 403 acquired at Step S31 to the frequency characteristic that takes into consideration the auditory characteristic.

At the subsequent Step S33, the EQ setting unit 204 creates the parameter 401 of the equalizer 12 that is used to correct the frequency characteristic of the audio signal in accordance with the frequency characteristic converted by the converting unit 203 at Step S32. Then, the EQ setting unit 204 sets, at the subsequent Step S34, the created parameter 401 in the equalizer 12.

By repeatedly performing the processes at Step S30 to Step S34 described above at, for example, a predetermined interval, it is possible to suppress the masking of the road noise generated in the vehicle 100 with respect to the car audio device 1b in substantially real time without the road noise being picked up by the microphone 30.

The configuration is not limited to this. It is conceivable that the road noise correction unit 200b allows the vehicle speed information acquiring unit 230 to determine whether the travelling speed of the vehicle 100 varies on the basis of the speed information 406 acquired at Step S30 and, when it is determined that the travelling speed has been varied, performs the processes at Step S31 to Step S34.

The invention as claimed In the following, the invention as set out in the appended claims will be described. As one of the human auditory characteristics, there is a delay of perception with respect to variations in sounds. Namely, human auditory has a characteristic indicating a fast response to a variation in a sound that is increased and a slow response to a variation in a sound that is decreased. Here, the magnitude of the road noise tends to be greater as the travelling speed of the vehicle 100 is increased, whereas the magnitude of the road noise tends to be smaller as the travelling speed is decreased. In other words, at the time of the speed acceleration and deceleration of the vehicle 100, the road noise suddenly varies.

In the invention, the road noise correction unit 200b determines whether the vehicle 100 accelerates or decelerates its speed by monitoring the speed information 406 acquired by the vehicle speed information acquiring unit 230 and allows, in accordance with the determination result, the setting of the parameter 401 that is set in the equalizer 12 by the EQ setting unit 204 to be delayed.

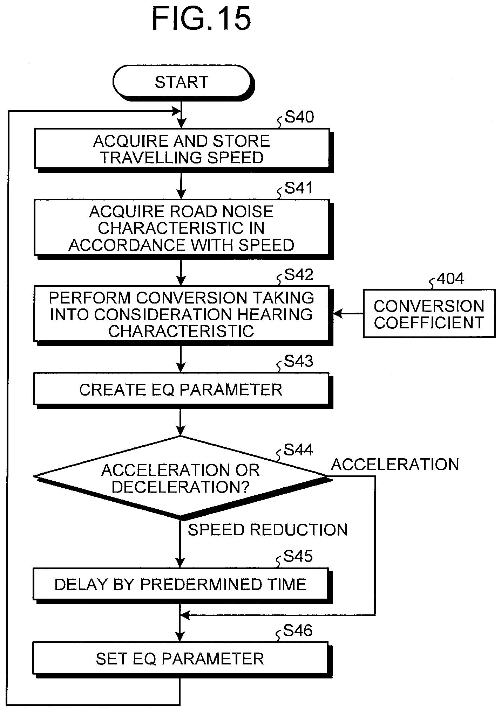

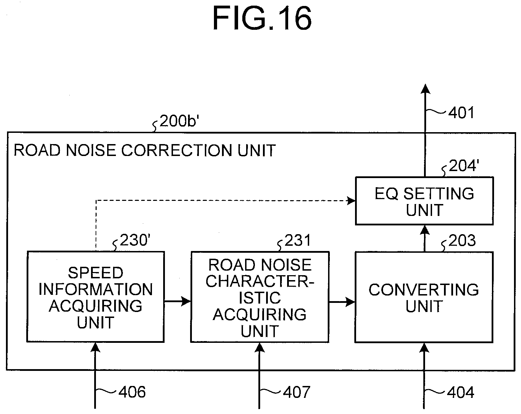

FIG. 15 is a flowchart illustrating the process according to the invention. Furthermore, FIG. 16 is a functional block diagram illustrating an example of the function performed by a road noise correction unit 200b' according to the invention. Furthermore, in FIG. 16, components that are the same as those in FIG. 13 are assigned the same reference numerals and descriptions thereof will be omitted. The configuration exemplified in FIG. 16 differs from the configuration exemplified in FIG. 13 described above in a part of the function of a vehicle speed information acquiring unit 230' and an EQ setting unit 204'.

In the road noise correction unit 200b', the vehicle speed information acquiring unit 230' acquires, at Step S40, the travelling speed of the vehicle 100 on the basis of the speed information 406 supplied from the vehicle 100. Furthermore, the vehicle speed information acquiring unit 230' monitors the speed information 406 and detects a variation in a travelling speed. The vehicle speed information acquiring unit 230' supplies, to the EQ setting unit 204' in accordance with the result of the detection, speed variation information that indicates at least deceleration of the travelling speed.

At the subsequent Step S41, the road noise characteristic acquiring unit 231 acquires, from the storing unit 21, the frequency characteristic 407 of the road noise signal 403 that is associated with the travelling speed acquired at Step S40. At the subsequent Step S42, the converting unit 203 converts, by using, for example, the conversion coefficient 404 on the basis of the A characteristic read from the storing unit 21, the frequency characteristic of the road noise signal 403 acquired at Step S41 to the frequency characteristic that takes into consideration the auditory characteristic.

At the subsequent Step S43, the EQ setting unit 204' creates the parameter 401 of the equalizer 12 that is used to correct the frequency characteristic of the audio signal in accordance with the frequency characteristic converted by the converting unit 203 at Step S42.

At the subsequent Step S44, the EQ setting unit 204' determines, on the basis of the speed variation information supplied from the vehicle speed information acquiring unit 230', whether the vehicle 100 has decelerated. If the EQ setting unit 204' determines that the vehicle 100 has decelerated, the EQ setting unit 204' allows the process to move to Step S45; after the process is delayed by waiting for a predetermined time, allows the process to move to Step S46; and sets the parameter 401 created at Step S43 in the equalizer 12.

The delay time of the process at Step S45 is set to, for example, about 200 msec. The delay time at Step S45 is not limited to 200 msec. and another value may also be set. Furthermore, a delay time may also be set by a user operation with respect to, for example, the operating unit 22.

In contrast, at Step S44, if the EQ setting unit 204' determines no deceleration of the vehicle 100, i.e., determines acceleration or no change in the travelling speed, the EQ setting unit 204' allows the process to move to Step S46 without setting a standby time and then sets the parameter 401 created at Step S43 in the equalizer 12.

By repeatedly performing the processes at Step S40 to Step S46 described above at, for example, a predetermined interval, it is possible to suppress the masking of the road noise generated in the vehicle 100 with respect to the car audio device 1b in substantially real time without the road noise being picked up by the microphone 30.

The configuration is not limited to this. It is conceivable that the road noise correction unit 200b' allows the speed information acquiring unit 230' to determine whether the travelling speed of the vehicle 100 varies on the basis of the speed information 406 acquired at Step S40 and, when it is determined that the travelling speed has been varied, performs the processes at Step S41 to Step S46. In this case, at Step S44, deceleration or acceleration may be determined.

Another example In the description above, the frequency characteristic of the road noise signal 403 is converted to the frequency characteristic that takes into consideration the auditory characteristic and the frequency characteristic of the equalizer 12 is set in accordance with the converted frequency characteristic. In another example, furthermore, the car audio devices 1a and 1b can perform, when the magnitude of a playback sound that is output from the speaker 16 is small, a loudness correction process that enhances the high frequency and the low frequency in accordance with the equal-loudness contours without being interlocked with a correction process performed on the frequency characteristic that takes into consideration the auditory characteristic in accordance with road noise.

Namely, for example, a case in which, in the car audio device 1a, the level of an audio signal is decreased by the sound volume adjustment unit 14 in accordance with the sound volume control value 402 that is output from the control unit 20a is considered. In this case, in accordance with the equal-loudness contours, it is not easy for a person to perceive the high frequency and the low frequency of a playback sound that are output from the speaker 16. Thus, in the control unit 20a, the sound volume control unit 220 creates the loudness correction value 400 in accordance with the sound volume control value 402, supplies the loudness correction value 400 to the loudness correction unit 11, and enhances the high frequency and the low frequency in accordance with the equal-loudness contours without being interlocked with the process performed by the road noise correction unit 200a.

### Reference Signs List

1a, 1b car audio device
10 audio playback unit
11 loudness correction unit
12 equalizer
20a, 20b control unit
21 storing unit
22 operating unit
30 microphone
100 vehicle
200a, 200b road noise correction unit
201 road noise acquiring unit
202a, 202b, 200b' analyzing unit
203 converting unit
204, 204' EQ setting unit
220 sound volume adjustment unit
230, 230' vehicle speed information acquiring unit
231 road noise characteristic acquiring unit

## Claims

1. An acoustic device (1a, 1b) comprising:
an equalizer (12) arranged to correct, in accordance with a parameter (401) to be set in the equalizer (12), a frequency characteristic of an audio signal that is played back by a playback unit (10); a vehicle speed
acquiring unit (230, 230') arranged to acquire a travelling speed (406);
a storing unit (21) arranged to store therein, for each travelling speed (406), one of the frequency characteristics of external noise (403); and
an acquiring unit (201) arranged to acquire, from the storing unit (21), the frequency characteristic of the external noise (403) associated with the travelling speed (406) acquired by the vehicle speed acquiring unit (230, 230'); **characterized in that**,
the acoustic device (1a, 1b) further comprises:
a converting unit (203) arranged to convert the frequency characteristic of the external noise (403) acquired by the acquiring unit (201) into an auditory sensitivity characteristic by weighting the frequency characteristic of the external noise with the A-weighting characteristic; and
a setting unit (204') arranged to set the parameter (401) in accordance with the auditory sensitivity characteristic of the external noise which is weighted by the A-weighting characteristic, and to delay the setting of the parameter (401) according to the vehicle celeration determined from the travelling speed variation.

2. The acoustic device (1a, 1b) of claim 1, wherein, in the converting unit (203), the resulting auditory sensitivity characteristic comprises a sound pressure level peak between 100Hz and 300Hz which decreases towards lower and higher frequency.

3. An acoustic processing method comprising:
a vehicle speed acquiring step (S30, S40) of acquiring a travelling speed (406);
a storing step (S31, S41) of storing, for each travelling speed (406), one of the frequency characteristics of external noise (403);
an acquiring step (S11, S21, S31) of acquiring the frequency characteristic of external noise (403) stored at the storing step (S31, S41) associated with the travelling speed (406) acquired by the vehicle speed acquiring step (S30, S40), **characterized in that**
the acoustic processing method further comprises:
a converting step (S12, S24, S32) of converting the frequency characteristic of the external noise (403) acquired at the acquiring step (S11, S21, S31) into an auditory sensitivity characteristic by weighting the frequency characteristic of the external noise with the A-weighting characteristic, and
a setting step (S14, S26, S34) of setting a parameter (401) in an equalizer (12), said parameter being in accordance with the auditory sensitivity characteristic of the external noise which is weighted by the A-weighting characteristic, and delaying the setting of the parameter (401) according to the vehicle acceleration determined from the travelling speed variation.

4. The acoustic processing method of claim 3, wherein, in the converting step (S12, S24, S32), the resulting auditory sensitivity characteristic comprises a sound pressure level peak between 100Hz and 300Hz which decreases towards lower and higher frequency.

5. A computer-readable recording medium having stored therein a program that causes a computer to execute a process comprising:
a vehicle speed acquiring step (S30, S40) of acquiring a travelling speed (406);
a storing step (S31, S41) of storing, for each travelling speed (406), one of the frequency characteristics of external noise (403);
an acquiring step (S11, S21, S31) of acquiring the frequency characteristic of external noise (403) stored at the storing step (S31, S41) associated with the travelling speed (406) acquired by the vehicle speed acquiring step (S30, S40), **characterized in that** the acoustic processing method further comprises:
a converting step (S12, S24, S32) of converting the frequency characteristic of the external noise (403) acquired at the acquiring (S11, S21, S31) step into an auditory sensitivity characteristic by weighting the frequency characteristic of the external noise with the A-weighting characteristic,; and
a setting step (S14, S26, S34) of setting a parameter(401) in an equalizer (12), said parameter being in accordance with the auditory sensitivity characteristic of the external noise which is weighted by the A-weighting characteristic, and delaying the setting of the parameter (401) according to the vehicle acceleration determined from the travelling speed variation.

6. The computer-readable recording medium of claim 5, wherein, in the converting step (S12, S24, S32), the resulting auditory sensitivity characteristic comprises a sound pressure level peak between 100Hz and 300Hz which decreases towards lower and higher frequency.

## Patentansprüche

1. Eine akustische Vorrichtung (1a, 1b), die Folgendes aufweist:
ein Equalizer (12) angeordnet zum Korrigieren, gemäß einem Parameter (401), der in dem Equalizer (12) einzustellen ist, einer Frequenzcharakteristik eines Audiosignals, das von einer Abspieleinheit (10) abgespielt wird;
eine Fahrzeug Geschwindigkeit Beschaffungseinheit (230, 230') angeordnet zum Beschaffen einer Reisegeschwindigkeit (406);
eine Speichereinheit (21) angeordnet zum darin Speichern, für jede Reisegeschwindigkeit (406), eine der Frequenzcharakteristika von externem Rauschen (403); und
eine Beschaffungseinheit (201) angeordnet zum Beschaffen, von der Speichereinheit (21), der Frequenzcharakteristik von dem externen Rauschen (403) verknüpft mit der Reisegeschwindigkeit (406), die von der Fahrzeug Geschwindigkeit Beschaffungseinheit (230, 230') beschafft wurde; **gekennzeichnet dadurch, dass**
die akustische Vorrichtung (1a, 1b) ferner Folgendes aufweist:
eine Verarbeitungseinheit (203) angeordnet zum Verarbeiten der Frequenzcharakteristik von dem externen Rauschen (403), die von der Beschaffungseinheit (201) beschafft wurde, in eine auditiv sensitive Charakteristik durch gewichten der Frequenzcharakteristik von dem externen Rauschen mit der A-Gewichtungscharakteristik; und
eine Einstelleinheit (204') angeordnet zum Einstellen des Parameters (401) gemäß der auditiv sensitiven Charakteristik von dem externen Rauschen, die durch die A-Gewichtungscharakteristik gewichtet ist, und zum Verzögern des Einstellen des Parameters (401) gemäß der Fahrzeugbeschleunigung bestimmt aus der Reisegeschwindigkeitsänderung.

2. Die akustische Vorrichtung (1a, 1b) nach Anspruch 1, wobei, in der Verarbeitungseinheit (203), die resultierende auditiv sensitive Charakteristik eine Schalldruckpegel Spitze zwischen 100Hz und 300 Hz aufweist, die in Richtung niedrigerer und höherer Frequenzen abnimmt.

3. Ein akustisches Verarbeitungsverfahren, das Folgendes aufweist:
einen Fahrzeug Geschwindigkeit Beschaffungsschritt (S30, S40) zum Beschaffen einer Reisegeschwindigkeit (406);
einen Speicherschritt (S31, S41) zum Speichern, für jede Reisegeschwindigkeit (406), eine der Frequenzcharakteristika von externem Rauschen (403);
einen Beschaffungsschritt (S11, S21, S31) zum Beschaffen der Frequenzcharakteristik von dem externen Rauschen (403), gespeichert in dem Speicherschritt (S31, S41), verknüpft mit der Reisegeschwindigkeit (406), beschafft durch den Fahrzeug Geschwindigkeit Beschaffungsschritt (S30, S40), **gekennzeichnet dadurch, dass**
das akustische Verarbeitungsverfahren ferner Folgendes aufweist:
einen Verarbeitungsschritt (S12, S24, S32) zum Verarbeiten der Frequenzcharakteristik von dem externen Rauschen (403), beschafft bei dem Beschaffungsschritt (S11, S21, S31), in eine auditiv sensitive Charakteristik durch gewichten der Frequenzcharakteristik von dem externen Rauschen mit der A-Gewichtungscharakteristik; und
einen Einstellungsschritt (S14, S26, S34) zum Einstellen eines Parameters (401) in einem Equalizer (12), wobei der Parameter der auditiv sensitiven Charakteristik von dem externen Rauschen entspricht, die durch die A-Gewichtungscharakteristik gewichtet ist, und zum Verzögern des Einstellen des Parameters (401) gemäß der Fahrzeugbeschleunigung bestimmt aus der Reisegeschwindigkeitsänderung.

4. Das akustisches Verarbeitungsverfahren nach Anspruch 3, wobei, in dem Verarbeitungsschritt (S12, S24, S32), die resultierende auditiv sensitive Charakteristik eine Schalldruckpegel Spitze zwischen 100Hz und 300 Hz aufweist, die in Richtung niedrigerer und höherer Frequenzen abnimmt.

5. Ein computer-lesbares Speichermedium mit einem darauf gespeicherten Programm, das einen Computer veranlasst, einen Prozess auszuführen, der Folgendes aufweist:
einen Fahrzeug Geschwindigkeit Beschaffungsschritt (S30, S40) zum Beschaffen einer Reisegeschwindigkeit (406);
einen Speicherschritt (S31, S41) zum Speichern, für jede Reisegeschwindigkeit (406), eine der Frequenzcharakteristika von externem Rauschen (403);
einen Beschaffungsschritt (S11, S21, S31) zum Beschaffen der Frequenzcharakteristik von dem externen Rauschen (403), gespeichert in dem Speicherschritt (S31, S41), verknüpft mit der Reisegeschwindigkeit (406), beschafft durch den Fahrzeug Geschwindigkeit Beschaffungsschritt (S30, S40), **gekennzeichnet dadurch, dass**
das akustische Verarbeitungsverfahren ferner Folgendes aufweist:
einen Verarbeitungsschritt (S12, S24, S32) zum Verarbeiten der Frequenzcharakteristik von dem externen Rauschen (403), beschafft bei dem Beschaffungsschritt (S11, S21, S31), in eine auditiv sensitive Charakteristik durch gewichten der Frequenzcharakteristik von dem externen Rauschen mit der A-Gewichtungscharakteristik und
einen Einstellungsschritt (S14, S26, S34) zum Einstellen eines Parameters (401) in einem Equalizer (12), wobei der Parameter der auditiv sensitiven Charakteristik von dem externen Rauschen entspricht, die durch die A-Gewichtungscharakteristik gewichtet ist, und zum Verzögern des Einstellen des Parameters (401) gemäß der Fahrzeugbeschleunigung bestimmt aus der Reisegeschwindigkeitsänderung.

6. Das computer-lesbare Speichermedium nach Anspruch 5, wobei, in dem Verarbeitungsschritt (S12, S24, S32), die resultierende auditiv sensitive Charakteristik eine Schalldruckpegel Spitze zwischen 100Hz und 300Hz aufweist, die in Richtung niedrigerer und höherer Frequenzen abnimmt.

## Revendications

1. Dispositif acoustique (1a, 1b) comprenant :
un égaliseur (12) agencé pour corriger, conformément à un paramètre (401) à régler dans l'égaliseur (12), une caractéristique de fréquence d'un signal audio qui est reproduit par une unité de lecture (10) ;
une unité d'acquisition de vitesse d'un véhicule (230, 230') agencée pour acquérir une vitesse de déplacement (406) ;
une unité de stockage (21) agencée pour stocker en elle, pour chaque vitesse de déplacement (406), une des caractéristiques de fréquence de bruit externe (403) ; et
une unité d'acquisition (201) agencée pour acquérir, à partir de l'unité de stockage (21), la caractéristique de fréquence du bruit externe (403) associé à l'unité d'acquisition de vitesse d'un véhicule (230, 230') ;
**caractérisé en ce que**,
le dispositif acoustique (1a, 1b) comprend en outre :
une unité de conversion (203) agencée pour convertir la caractéristique de fréquence du bruit externe (403) acquise par l'unité d'acquisition (201) en une caractéristique de sensibilité auditive en pondérant la caractéristique de fréquence du bruit externe avec la caractéristique de pondération A ; et
une unité de réglage (204') agencée pour régler le paramètre (401) conformément à la caractéristique de sensibilité auditive du bruit externe qui est pondérée par la caractéristique de pondération A, et pour retarder le réglage du paramètre (401) conformément à l'accélération de véhicule déterminée à partir de la variation de vitesse de déplacement.

2. Dispositif acoustique (1a, 1b) selon la revendication 1, dans lequel, dans l'unité de conversion (203), la caractéristique de sensibilité auditive résultante comprend un pic de niveau de pression sonore entre 100 Hz et 300 Hz qui diminue vers des fréquences inférieures et supérieures.

3. Procédé de traitement acoustique comprenant :
une étape d'acquisition de vitesse de véhicule (S30, S40) d'acquisition d'une vitesse de déplacement (406) ;
une étape de stockage (S31, S41) de stockage, pour chaque vitesse de déplacement (406), d'une des caractéristiques de fréquence de bruit externe (403) ;
une étape d'acquisition (S11, S21, S31) d'acquisition de la caractéristique de fréquence de bruit externe (403) stockée à l'étape de stockage (S31, S41) associée à la vitesse de déplacement (406) acquise à l'étape d'acquisition de vitesse de véhicule (S30, S40),
**caractérisé en ce que**
le procédé de traitement acoustique comprend en outre :
une étape de conversion (S12, S24, S32) de conversion de la caractéristique de fréquence du bruit externe (403) acquise à l'étape d'acquisition (S11, S21, S31) en une caractéristique de sensibilité auditive en pondérant la caractéristique de fréquence du bruit externe avec la caractéristique de pondération A, et
une étape de réglage (S14, S26, S34) de réglage d'un paramètre (401) dans un égaliseur (12), ledit paramètre étant conforme à la caractéristique de sensibilité auditive du bruit externe qui est pondérée par la caractéristique de pondération A, et de retard du réglage du paramètre (401) conformément à l'accélération de véhicule déterminée à partir de la variation de vitesse de déplacement.

4. Procédé de traitement acoustique selon la revendication 3, dans lequel, à l'étape de conversion (S12, S24, S32), la caractéristique de sensibilité auditive résultante comprend un pic de niveau de pression sonore entre 100 Hz et 300 Hz qui diminue vers des fréquences inférieures et supérieures.

5. Support d'enregistrement lisible par ordinateur stockant en lui un programme qui amène un ordinateur à exécuter un procédé comprenant :
une étape d'acquisition de vitesse de véhicule (S30, S40) d'acquisition d'une vitesse de déplacement (406) ;
une étape de stockage (S31, S41) de stockage, pour chaque vitesse de déplacement (406), d'une des caractéristiques de fréquence de bruit externe (403) ;
une étape d'acquisition (S11, S21, S31) d'acquisition de la caractéristique de fréquence de bruit externe (403) stockée à l'étape de stockage (S31, S41) associée à la vitesse de déplacement (406) acquise à l'étape d'acquisition de vitesse de véhicule (S30, S40),
**caractérisé en ce que**
le procédé de traitement acoustique comprend en outre :
une étape de conversion (S12, S24, S32) de conversion de la caractéristique de fréquence du bruit externe (403) acquise à l'étape d'acquisition (S11, S21, S31) en une caractéristique de sensibilité auditive en pondérant la caractéristique de fréquence du bruit externe avec la caractéristique de pondération A et
une étape de réglage (S14, S26, S34) de réglage d'un paramètre (401) dans un égaliseur (12), ledit paramètre étant conforme à la caractéristique de sensibilité auditive du bruit externe qui est pondérée par la caractéristique de pondération A, et de retard du réglage du paramètre (401) en fonction de l'accélération de véhicule déterminée à partir de la variation de vitesse de déplacement.

6. Support d'enregistrement lisible par ordinateur selon la revendication 5, dans lequel, à l'étape de conversion (S12, S24, S32), la caractéristique de sensibilité auditive résultante comprend un pic de niveau de pression sonore entre 100 Hz et 300 Hz qui diminue vers des fréquences inférieures et supérieures.
